# EUROPÄISCHE PATENTSCHRIFT

(11) **EP 0 698 288 B1**
(45) Veröffentlichungstag und Bekanntmachung des Hinweises auf die Patenterteilung: **05.08.1998**
(21) Anmeldenummer: 94913486.0
(22) Anmeldetag: 02.05.1994
(51) Int. Cl.: H01L 21/98, H01L 25/065

(54) **HERSTELLUNGSVERFAHREN FÜR VERTIKAL KONTAKTIERTE HALBLEITERBAUELEMENTE**
PROCESS FOR PRODUCING VERTICALLY CONNECTED SEMICONDUCTOR COMPONENTS
PROCEDE DE FABRICATION DE COMPOSANTS SEMICONDUCTEURS A INTERCONNEXIONS VERTICALES

(30) Priorität: 05.05.1993 DE 4314907
(43) Veröffentlichungstag der Anmeldung: 28.02.1996
(73) Patentinhaber: SIEMENS AKTIENGESELLSCHAFT, 80333 München (DE)
(72) Erfinder: BERTAGNOLLI, Emmerich, Dr., D-80799 München (DE); KLOSE, Helmut, Dr., D-81929 München (DE)
(86) Internationale Anmeldenummer: DE9400486
(87) Internationale Veröffentlichungsnummer: WO9425981

(56) Entgegenhaltungen:
- EP-A- 0 238 089
- WO-A-92/03848
- US-A- 4 394 712

## Beschreibung

Die vorliegende Erfindung betrifft ein Verfahren zur Herstellung von Halbleiterbauelementen mit einer speziellen Kontaktstrukturierung, die für eine vertikale elektrisch leitende Verbindung von mehreren Halbleiterbauelementen vorgesehen ist.

Halbleiterschaltungen werden heute in Planartechnik hergestellt. Die erreichbare Komplexität auf einem Chip ist begrenzt durch dessen Größe und die erreichbare Strukturfeinheit. Die Leistungsfähigkeit eines Systems bestehend aus mehreren miteinander verbundenen Halbleiterchips ist bei konventioneller Technik wesentlich begrenzt durch die begrenzte Zahl der möglichen Verbindungen zwischen einzelnen Chips über Anschlußkontakte, die geringe Geschwindigkeit der Signalübermittlung über solche Verbindungen zwischen verschiedenen Chips, die bei komplexen Chips begrenzte Geschwindigkeit durch weit verzweigte Leiterbahnen und den hohen Leistungsverbrauch der Interface-Schaltungen.

Diese aufgezeigten Beschränkungen bei der Verwendung der Planartechnik lassen sich mit dreidimensionalen Techniken der Verschaltung überwinden. Die Anordnung der Funktionsebenen übereinander erlaubt eine parallele Kommunikation dieser Komponenten mit geringem Aufwand elektrisch leitender Verbindungen in einer Ebene, und außerdem werden geschwindigkeitbegrenzende Interchip-Verbindungen vermieden.

Ein bekanntes Verfahren, dreidimensionale IC's herzustellen, beruht darauf, über einer Ebene von Bauelementen eine weitere Halbleiterschicht abzuscheiden und diese über ein geeignetes Verfahren (z. B. lokale Erwärmung mittels Lasers) zu rekristallisieren und darin eine weitere Bauelementeebene zu realisieren. Auch diese Technik weist wesentliche Begrenzungen auf, die durch die thermische Belastung der unteren Ebene bei der Rekristallisierung und die durch Defekte begrenzte erreichbare Ausbeute gegeben sind.

Ein alternatives Verfahren von NEC stellt die einzelnen Bauelementeebenen getrennt voneinander her. Diese Ebenen werden auf wenige µm gedünnt und mittels Wafer-bonding miteinander verbunden. Die elektrischen Verbindungen werden in der Weise hergestellt, daß die einzelnen Bauelementeebenen auf der Vorder- und Rückseite mit Kontakten zur Interchip-Verbindung versehen werden. Dieses Verfahren hat folgende Nachteile und Einschränkungen:
Die gedünnten Scheiben müssen auf der Vorderseite und auf der Rückseite in technischen Prozessen bearbeitet werden (Lithographie mit Justierung durch die Halbleiterscheibe). Das Testen auf Funktionstüchtigkeit der einzelnen Ebenen vor dem Zusammenfügen ist dadurch erschwert, daß bei diesem Verfahren in jeder Ebene einzelne Bauelemente, aber nicht vollstandige Schaltungen realisiert werden. Durch das Dünnen der Scheiben bis auf die Funktionselemente entstehen SOI-ähnliche Bauelementestrukturen, so daß keine mit Standardtechnologien (z. B. Standard-CMOS) vorgefertigten Scheiben verwendet werden können.

Weitere alternative Verfahren für Kontaktierung von Halbleiterbauelementen sind aus den Dokumente WO-A-9 203 848, US-A-4 394 712 und EP-A-0 238 089 bekannt.

Aufgabe der vorliegenden Erfindung ist es, ein Verfahren für die einfache Herstellung von Halbleiterbauelementen mit einer für dreidimensionale Kontaktierung geeigneten Kontaktstrukturierung anzugeben sowie ein Verfahren für die elektrisch leitende Kontaktierung mehrerer derartiger Halbleiterbauelemente.

Diese Aufgabe wird mit dem Verfahren mit den Schritten des Anspruches 1 gelöst. Weitere Ausgestaltungen ergeben sich aus den abhängigen Ansprüchen.

Bei dem erfindungsgemäßen Herstellungsverfahren wird die Kontaktstrukturierung hergestellt, indem das Substrat des Bauelementes von der überwachsenen Oberseite ausgehend soweit vertikal ausgeätzt wird, daß in diese stiftförmige Aussparung eine Metallisierung eingebracht werden kann, die mit der zu kontaktierenden Metallschicht oder Halbleiterschicht elektrisch leitend kontaktiert wird. Die Unterseite des Substrates wird soweit rückgeschliffen oder rückgeätzt, daß diese stiftförmige Metallisierung auf der Unterseite über das Substrat hinausragt. Mit diesem herausragenden Stift kann dieses Halbleiterbauelement mit einem geeignet hergestellten Kontakt aus niedrig schmelzendem Metall auf der Oberseite eines weiteren Halbleiterbauelementes dauerhaft elektrisch leitend verbunden werden.

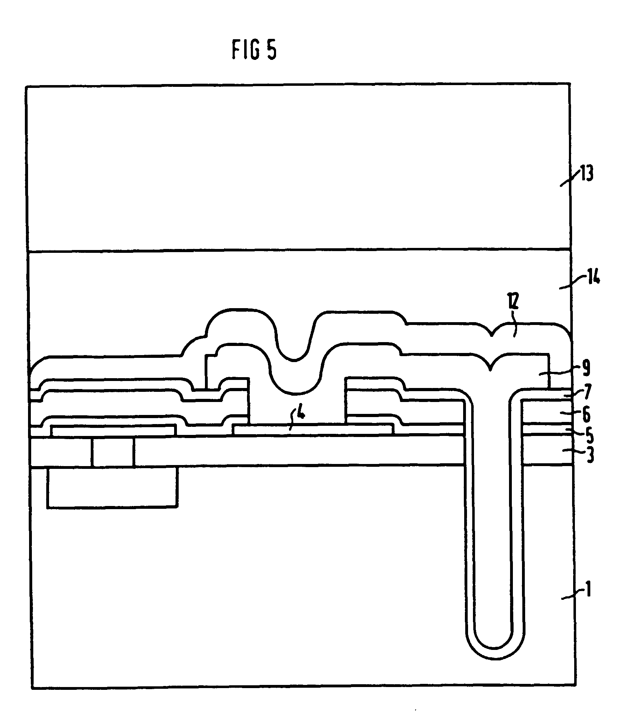

Es folgt eine Beschreibung des erfindungsgemäßen Verfahrens anhand der Figuren 1 bis 8.
- Fig. 1 bis 5: zeigen ein erfindungsgemäß hergestelltes Bauelement nach verschiedenen Schritten des Herstellungsverfahrens im Querschnitt.
- Fig. 6 und 7: zeigen ein weiteres, damit zu kontaktierendes Halbleiterbauelement nach verschiedenen Schritten des Herstellungsverfahrens im Querschnitt.
- Fig. 8: zeigt zwei erfindungsgemäß vertikal kontaktierte Bauelemente im Querschnitt.

In den Figuren sind der Übersichtlichkeit halber die in Blickrichtung hinteren Konturen der Schichtstruktur in den im Beispiel zumeist runden Öffnungen weggelassen.

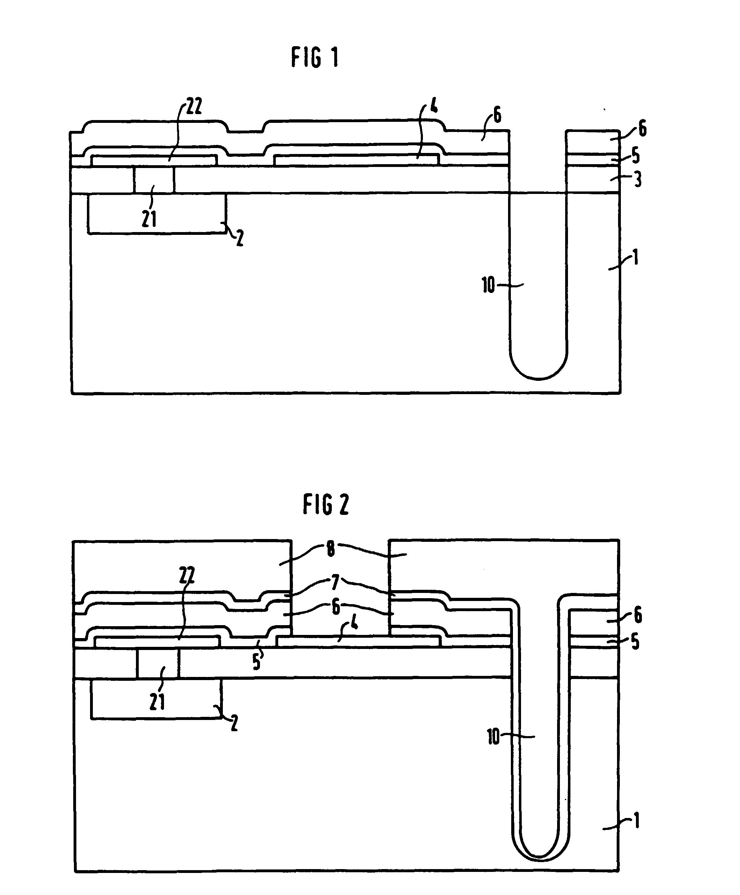

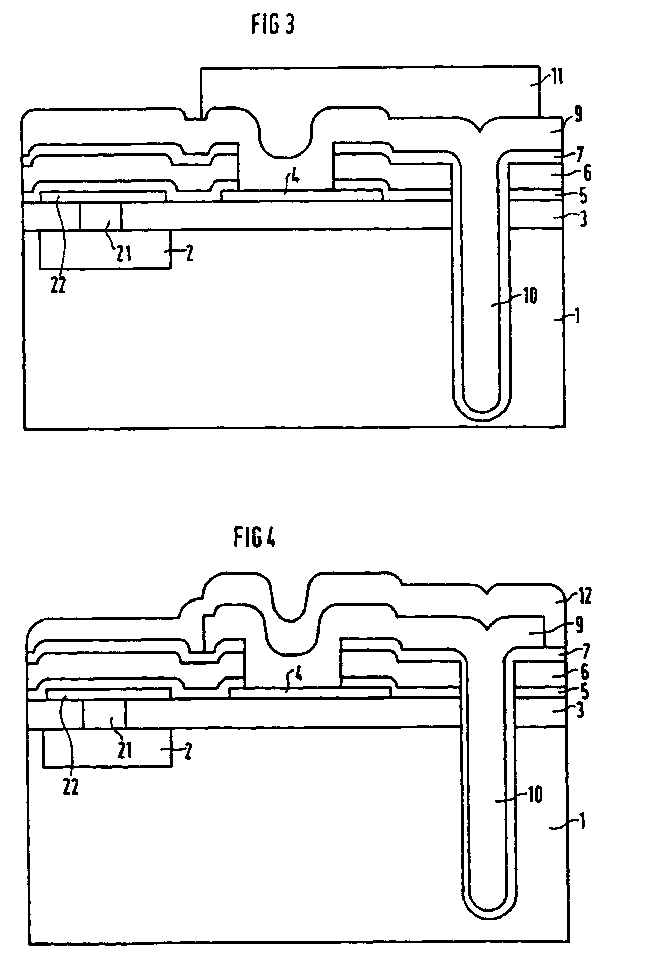

Bei dem erfindungsgemäßen Herstellungsverfahren können die Halbleiterbauelemente auf mit Standard-Technologien vorgefertigten Halbleiterscheiben, z. B. aus Silizium, hergestellt werden. Es sind keine Eingriffe in die üblichen Basistechnologien nötig, da die für die vertikale Verbindung nötige Modifikation der Kontaktstrukturierung in Prozeßschritten am Schluß des Herstellungsprozesses vorgenommen werden. Ausgehend von einem Substrat wird die für das Halbleiterbauelement vorgesehene Schichtstruktur z. B. aus Halbleiterschichten, dotierten Bereichen und Metallisierungen und Metallisierungsebenen wie z. B. Leiterbahnen hergestellt. In Fig. 1 ist als Beispiel das Substrat 1 mit einem darin oder darauf hergestellten Bereich 2, der zu einem Funktionselement gehört, dargestellt. Dieser Bereich 2 wird mittels einer Kontaktverbindung 21 (Plug) in einer Isolationsschicht 3 mit einem Metallkontakt 22, der z. B. auch Bestandteil von Leiterbahnen sein kann, elektrisch leitend verbunden. Ein weiterer Metallkontakt 4 soll in diesem Ausführungsbeispiel mit einem zweiten Halbleiterbauelement elektrisch verbunden werden. Es ist zweckmäßig, aber nicht notwendig, die gesamte Oberfläche mit einer Passivierung 5 z. B. aus Oxidnitrid (d. h. einer Mischung aus Oxid und Nitrid) zu bedecken. Darauf wird ganzflächig eine Dielektrikumschicht 6 (z. B. Oxid, insbesondere SiO₂) abgeschieden. Unter Verwendung einer Maske werden diese Schichten sowie die Schichtstruktur und das Material des Substrates in einem für die vertikalen leitenden Verbindungen vorgesehenen Bereich ausgeätzt. Auf diese Weise erhält man die in Fig. 1 eingezeichnete, z. B. stiftförmige Aussparung 10, die für die nachfolgenden Verfahrensschritte ausreichend tief ausgeätzt wird. Die so entstehende Oberfläche wird mit einer weiteren Passivierung 7 z. B. aus Oxid ganzflächig bedeckt.

Fig. 2 zeigt eine auf diese Struktur aufgebrachte Maske 8 aus z. B. Fotolack. Mit Hilfe dieser Maske wird die Oberfläche des anzuschließenden Metallkontaktes 4 freigelegt. Nachdem diese Maske 8 entfernt wurde, kann das für die Kontaktstruktur vorgesehene Metall aufgebracht werden. Es eignet sich hierfür insbesondere Wolfram, das z. B. mittels CVD aufgebracht wird. Wie in Fig. 3 dargestellt, wird mit diesem Metall 9 die Aussparung 10 in dem Substrat aufgefüllt und ein damit verbundener Kontakt auf der Oberfläche des Metallkontaktes 4 hergestellt. Dieser Metallkontakt 4 ist daher über das Metall 9 elektrisch leitend mit dem stiftförmigen Anteil dieses Metalles 9 der Aussparung 10 des Substrates verbunden.

Die in Fig. 3 dargestellte Struktur wird anschließend mit einer weiteren Maske 11 z. B. aus Fotolack derart strukturiert, daß von dem Metall 9 der auf dem Metallkontakt 4 verbleibende Anteil sowie der damit elektrisch leitend verbundene vertikale stiftförmige Anteil in der Aussparung 10 des Substrates übrig bleiben. Die Oberfläche wird erneut mit einer Passivierung 12 bedeckt. Durch die Passivierung 7 unter dem aufgebrachten Metall 9 ist der stiftförmige Anteil dieses Metalles 9 von dem umgebenden Material insbesondere der Schichtstruktur elektrisch isoliert.

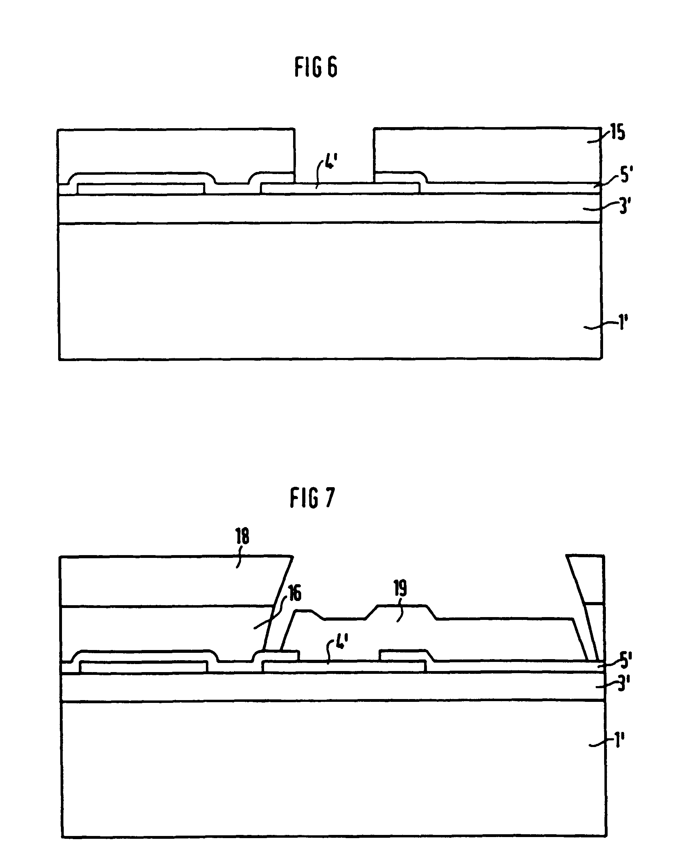

In der hier beispielhaft dargestellten Weise kann nicht nur ein derartiger Metallkontakt 4, sondern auch ein Bereich einer Leiterbahn oder eine Kontaktschicht aus Halbleitermaterial mit einem vertikalen Anteil dieser herzustellenden Kontaktstrukturierung verbunden werden. Es können auch mehrere derartige Metallisierungen hergestellt werden, um mehrere Metallkontakte oder Kontaktschichten jeweils mit einem vertikalen stiftförmigem Anteil einer Kontaktstrukturierung zu verbinden. Auf diese Weise können mehrere Kontakte eines Halbleiterbauelementes, das erfindungsgemäß hergestellt wurde, mit einem vertikal darunter angeordneten Halbleiterbauelement mit entsprechenden Anschlußkontakten elektrisch leitend verbunden werden. Um die Metallstifte mit einem weiteren Halbleiterbauelement auf der Unterseite des Substrates 1 verbinden zu können, wird das Substrat 1 von der Rückseite her soweit entfernt, z. B. durch Rückschleifen (z. B. CMP, Chemical Mechanical Polishing) oder Rückätzen, daß die vertikalen Metallstifte des Metalles 9 auf dieser Rückseite des Substrates aus dem Substrat herausragen. Dieser Verfahrensschritt wird erleichtert, wenn auf der Seite mit der Schichtstruktur ein weiteres Substrat 13 angebracht wird. Dieses weitere Substrat 13 kann z. B. mit einer Haftschicht 14 befestigt werden, wie in Fig. 5 dargestellt ist. Diese Haftschicht 14 kann z. B. Polyimid oder Epoxyharz sein. Die vertikale Kontaktierung mit einem weiteren Bauelement erfolgt in der Weise, daß dort, wo der Metallstift die Substratunterseite des ersten Bauelementes überragt, ein entsprechender Kontakt aus Metall auf dem zweiten Bauelement hergestellt wird. In Fig. 6 ist ein solches weiteres Bauelement im Querschnitt dargestellt. Der Metallkontakt 4' dieses Bauelementes soll elektrisch leitend mit dem Metallkontakt 4 des ersten Bauelementes verbunden werden, wobei diese Bauelemente vertikal übereinander anzuordnen sind. Auf dem Substrat 1' dieses zweiten Bauelementes befindet sich wieder eine Schichtstruktur, die z. B. mit einer Isolationsschicht 3' bedeckt oder in diese Isolationsschicht eingebettet ist. Die Oberfläche ist mit einer Passivierung 5' bedeckt. Mittels einer Maske 15 z. B. aus Fotolack wird die Oberfläche des zu kontaktierenden Metallkontaktes 4' freigelegt. Entsprechend Fig. 7 wird eine Metallisierung 18, 19 auf diese Oberfläche des Metallkontaktes 4' aufgebracht. Zu diesem Zweck wird entweder die Öffnung in der Maske 15 vergrößert, oder es wird diese Maske 15 entfernt und eine neue Maske 16 z. B. aus Fotolack aufgebracht. Die Metallisierung wird abgeschieden, wobei ein Anteil 18 (s. Fig. 7) auf der Maske 16 abgeschieden wird und zusammen mit dieser Maske in einem weiteren Verfahrensschritt entfernt wird. Der verbleibende Anteil 19 dieser Metallisierung in der Öffnung der Maske 16 ist so bemessen, daß der Metallkontakt 4' von dieser Metallisierung 19 kontaktiert wird und außerdem ein Anteil dieser Metallisierung 19 in dem Bereich, der für die Kontaktierung mit dem ersten Halbleiterbauelement vorgesehen ist, vorhanden ist. Als Metall wird vorzugsweise ein Metall mit niedrigerem Schmelzpunkt als das sonst für Metallisierungen und Leiterbahnen üblicherweise verwendete Metall verwendet. Es kommt z. B. AuIn dafür in Frage.

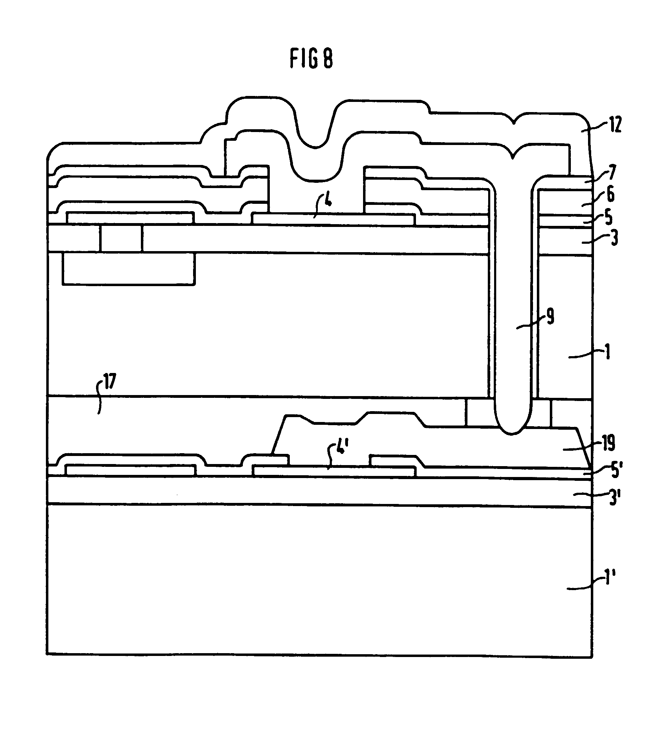

Die Verbindung der beiden in diesen Beispielen dargestellten Bauelemente erfolgt dann wie in Fig. 8 dargestellt. Die Bauelemente werden übereinander angeordnet und geeignet zueinander justiert. Um das untere Halbleiterbauelement zu dem darüber anzuordnenden ausrichten zu können, ist dessen Oberfläche mit einer Planarisierung 17 eingeebnet. Für die Kontaktierung ist oberhalb des für die Kontaktierung vorgesehenen Bereiches der Metallisierung 19 eine Öffnung in dieser Planarisierung 17 hergestellt. Durch Erwärmen wird das Metall der Metallisierung 19 des unteren Bauelementes zumindest soweit geschmolzen oder erweicht, daß durch Aufeinanderpressen der Bauelemente der Metallstift 9 in diese Metallisierung 19 hineingepreßt und dauerhaft damit verbunden werden kann. Da das Metall der Metallisierung 19 einen niedrigeren Schmelzpunkt aufweist, werden die Halbleiterstrukturen und sonstigen Metallisierungen bei diesem Verfahrensschritt nicht in Mitleidenschaft gezogen. Es können wie bereits erwähnt mehrere derartige Kontaktierungen zwischen den beiden vertikal zueinander angeordneten Bauelementen hergestellt werden. Auf diese Weise ist es möglich, mittels dieser Metallstifte der erfindungsgemäß hergestellten Kontaktstrukturierung verschiedene Metallkontakte oder Kontaktschichten des einen Bauelementes mit jeweils einem Kontakt des zweiten Bauelementes elektrisch zu verbinden.

Bei dem erfindungsgemäßen Verfahren erfolgt die Herstellung der elektrischen Kontakte auf der Vorderseite und der Rückseite eines Bauelementes ausschließlich durch Herstellungsverfahren, die von der mit der Schichtstruktur versehenen Oberseite des Bauelementes her vorgenommen werden. Dieses Verfahren ist daher besonders dafür geeignet, komplexe Systeme zu realisieren mit hohem Aufwand an elektrischer Verbindung. Die einzelnen vertikal miteinander verbundenen Halbleiterebenen müssen keine reinen Bauelementeebenen sein, sondern sind vorzugsweise ganze Schaltungsebenen, die mit Standardtechnologien (z. B. CMOS, Bipolartechnik oder Speicherherstellung mit Mehrlagenverdrahtung) vorgefertigt werden können. Dadurch können die einzelnen Schaltungsebenen vor dem Zusammenfügen vertikal zueinander anzuordnender Halbleiterbauelemente getestet werden, wodurch die Ausbeute erhöht wird, weil nur funktionsfähige Komponenten miteinander kombiniert werden. Mit dem erfindungsgemäßen Verfahren ist es auch möglich, Sensoren oder Aktoren in der Form von Halbleiterbauelementen herzustellen. Das erfindungsgemäße Verfahren läßt sich in idealer Weise mit den Standardtechnologien der Herstellung von Bauelementen der Mikroelektronik kombinieren. Eine Realisierung in Silizium ist besonders vorteilhaft, weil dann SOI-Substrate (silicon on insulator) mit einer auf einer Isolationsschicht befindlichen Nutzschicht aus Silizium als Ausgangsmaterial verwendet werden können. Das erfindungsgemäße Verfahren für die Herstellung dreidimensional integrierter Bauelemente ist modular, d. h. daß die einzelnen miteinander zu kontaktierenden Ebenen unabhängig voneinander hergestellt, getestet und dann miteinander verbunden werden können. Die geometrische Anordnung der Metallisierungen ist nicht auf die Ausführungsbeispiele beschränkt, sondern läßt sich beliebig ausgestalten. Die dadurch bedingten Einschränkungen der Halbleitertopologie sind daher minimal.

## Patentansprüche

1. Verfahren zur Herstellung eines Halbleiterbauelementes mit einer Kontaktstrukturierung für vertikale Kontaktierung mit
einem weiteren Halbleiterbauelement, bei dem in einem ersten Schritt auf einem Substrat (1) eine Schichtstruktur mit einer zu kontaktierenden Kontaktschicht aus Halbleitermaterial oder einem Metallkontakt (4) oder einer Leiterbahn hergestellt wird,
in einem zweiten Schritt unter Verwendung einer Maske eine vertikale Aussparung (10) bis zu einer für einen nachfolgenden vierten Schritt ausreichenden Tiefe von der mit dieser Schichtstruktur versehenen Seite ausgehend in dieses Substrat (1) geätzt wird,
in einem dritten Schritt in diese Aussparung (10) und auf eine Oberfläche der zu kontaktierenden Kontaktschicht aus Halbleitermaterial oder des Metallkontaktes (4) oder der Leiterbahn ein Metall (9) abgeschieden wird, so daß der in diese Aussparung (10) eingebrachte Anteil dieses Metalles (9) in elektrisch leitender Verbindung mit dem auf diese Oberfläche aufgebrachten Anteil dieses Metalles (9) ist, und
in einem vierten Schritt die der Schichtstruktur gegenüberliegende Seite des Substrates (1) soweit entfernt wird, daß das Metall (9) in der Aussparung (10) über diese Seite des Substrates hinausragt.

2. Verfahren zur Herstellung von vertikal miteinander elektrisch leitend kontaktierten Halbleiterbauelementen, bei dem in einem ersten Schritt ein erstes Halbleiterbauelement nach dem Verfahren nach Anspruch 1 und ein vertikal damit zu kontaktierendes zweites Halbleiterbauelement mit einer Schichtstruktur mit einer zu kontaktierenden Kontaktschicht aus Halbleitermaterial oder einem Metallkontakt (4') oder einer Leiterbahn hergestellt werden,
in einem zweiten Schritt unter Verwendung einer Maske auf diese Kontaktschicht aus Halbleitermaterial oder diesen Metallkontakt (4') oder diese Leiterbahn eine Metallisierung (19) aus einem Metall mit einem niedrigeren Schmelzpunkt als dem von Leiterbahnen bis in einen für die Kontaktierung mit dem ersten Halbleiterbauelement vorgesehenen Bereich aufgebracht wird,
in einem dritten Schritt die beiden Halbleiterbauelemente derart übereinander angeordnet werden, daß das aus der Aussparung (10) des Substrates (1) des ersten Halbleiterbauelementes hinausragende Metall (9) sich oberhalb des für Kontaktierung vorgesehenen Bereichs dieser Metallisierung (19) des zweiten Halbleiterbauelementes befindet und
in einem vierten Schritt durch Erwärmen dieser Metallisierung (19) ein dauerhafter elektrisch leitender Kontakt mit dem Metall (9) des ersten Halbleiterbauelementes hergestellt wird.

3. Verfahren nach Anspruch 2,
bei dem für das durch die Aussparung (10) des Substrates (1) des ersten Halbleiterbauelementes ragende Metall (9) Wolfram verwendet wird und
bei dem für die Metallisierung (19) mit niedrigerem Schmelzpunkt des zweiten Halbleiterbauelementes AuIn verwendet wird.

4. Verfahren nach einem der Ansprüche 1 bis 3,
bei dem die Halbleiterbauelemente in Silizium hergestellt werden.

## Claims

1. Process for producing a semiconductor component having a contact structure for making vertical contact with a further semiconductor component, in which
in a first step a layer structure having a contact layer, which is made of semiconductor material and with which contact is to be made, or a metal contact (4) or a conductor track is produced on a substrate (1),
in a second step, using a mask, a vertical recess (10) is etched into said substrate (1), starting from the side provided with said layer structure, to a depth which is sufficient for a subsequent fourth step,
in a third step a metal (9) is deposited into said recess (10) and onto a surface of the contact layer, which is made of semiconductor material and with which contact is to be made, or of the metal contact (4) or of the conductor track, with the result that that portion of said metal (9) which is introduced into said recess (10) is electrically conductively connected to that portion of said metal (9) which is applied to said surface, and
in a fourth step that side of the substrate (1) which is opposite the layer structure is removed until the metal (9) in the recess (10) projects beyond said side of the substrate.

2. Process for producing semiconductor components between which contact is made vertically and electrically conductively, in which
in a first step there are produced a first semiconductor component according to the process according to Claim 1 and a second semiconductor component which is to make vertical contact with said first semiconductor component and has a layer structure having a contact layer, which is made of semiconductor material and with which contact is to be made, or a metal contact (4') or a conductor track,
in a second step, using a mask, a metallization layer (19) made of a metal having a lower melting point than that of conductor tracks is applied to said contact layer made of semiconductor material or said metal contact (4') or said conductor track, as far as a region provided for making contact with the first semiconductor component,
in a third step the two semiconductor components are arranged above one another in such a way that the metal (9) projecting out of the recess (10) in the substrate (1) of the first semiconductor component is situated above the region, provided for contact-making, of said metallization layer (19) of the second semiconductor component, and
in a fourth step a permanent, electrically conductive contact with the metal (9) of the first semiconductor component is produced by heating said metallization layer (19).

3. Process according to Claim 2,
in which tungsten is used for the metal (9) projecting through the recess (10) in the substrate (1) of the first semiconductor component, and
in which AuIn is used for the metallization layer (19), having a lower melting point, of the second semiconductor component.

4. Process according to one of Claims 1 to 3,
in which the semiconductor components are produced using silicon.

## Revendications

1. Procédé de fabrication d'un composant semi-conducteur muni d'une structure de contact pour l'interconnexion verticale à un composant semi-conducteur supplémentaire, dans lequel dans une première étape une structure de couche est réalisée sur un substrat (1) ayant une couche de contact à interconnecter constituée de matière semi-conductrice ou d'un contact métallique (4) ou d'une voie conductrice,
dans une seconde étape, moyennant l'utilisation d'un masque, un évidement vertical (10) est gravé dans ce substrat (1) jusqu'à une profondeur suffisante pour une quatrième étape successive à partir de la face munie de cette structure de couche,
dans une troisième étape un métal (9) est déposé dans cet évidement (10) et sur une surface de la couche de contact à interconnecter constituée de matière semi-conductrice ou du contact métallique (4) ou de la voie conductrice, de telle sorte que la partie de ce métal (9) déposée dans cet évidement (10) se trouve en contact électroconducteur avec la partie de ce métal (9) déposée sur cette surface, et dans lequel la face du substrat (1) opposée à la structure de couche est enlevée dans une quatrième étape à un tel point que le métal (9) dans l'évidement (10) dépasse de cette face du substrat.

2. Procédé de fabrication de composants semi-conducteurs électroconducteurs à interconnecter verticalement, dans lequel dans une première étape un premier composant semi-conducteur est fabriqué d'après le procédé selon la revendication 1, et un second élément semi-conducteur à interconnecter verticalement avec celui-ci, comportant une structure de couche ayant une couche de contact à interconnecter constituée de matière semi-conductrice ou d'un contact métallique (4') ou d'une voie conductrice, dans une seconde étape, moyennant l'utilisation d'un masque, une métallisation (19) constituée d'un métal à point de fusion plus bas que celui des voies conductrices est déposée sur cette couche de contact constituée d'une matière semi-conductrice ou sur ce contact métallique (4') ou cette voie conductrice, jusque dans une zone prévue pour l'interconnexion avec le premier composant semi-conducteur,
dans une troisième étape, les deux composants semi-conducteurs sont superposés l'un sur l'autre de telle sorte que le métal (9) dépassant de l'évidement (10) du substrat (1) du premier composant semi-conducteur se trouve au-dessus de la zone de cette métallisation (19) du second composant semi-conducteur, prévue pour l'interconnexion et
dans une quatrième étape, par échauffement de cette métallisation (19) un contact électroconducteur durable est établi avec le métal (9) du premier composant semi-conducteur.

3. Procédé selon la revendication 2,
dans lequel le métal (9) utilisé dépassant de l'évidement (10) du substrat (1) du premier composant semi-conducteur est du tungstène et dans lequel l'Auln est utilisé pour la métallisation (19) à point de fusion plus bas du second composant semi-conducteur.

4. Procédé selon l'une des revendications 1 à 3,
dans lequel les composants semi-conducteurs sont réalisés en silicium.
